# EUROPÄISCHE PATENTANMELDUNG

(11) **EP 1 715 515 A1**
(43) Veröffentlichungstag der Anmeldung: **25.10.2006**
(21) Anmeldenummer: 06112179.4
(22) Anmeldetag: 03.04.2006
(51) Int. Cl.: H01L 21/687

(54) **Greifer zum Handhaben dünner scheibenförmiger Gegenstände**

(30) Priorität: 11.04.2005 AT 6152005
(71) Anmelder: mechatronic Systemtechnik GmbH, 9500 Villach (AT)
(72) Erfinder: Lang, Marcus, 9500, VILLACH (AT); Oremus, Alexander, 9500, VILLACH (AT)
(74) Vertreter: Brunnbauer, Gerhard

(57) **Zusammenfassung**

Gezeigt wird ein Greifer zum Handhaben dünner scheibenförmiger Gegenstände, insbesondere Wafer in der Halbleitertechnik, wobei der Greifer Ausströmöffnungen (3) aufweist, mit denen ein hydrodynamischer Unterdruck erzeugt werden kann, der eine zum Greifer gerichtete Kraft auf einen scheibenförmigen Gegenstand ausübt, und wobei der Greifer weiters Stabilisierungseinrichtungen (4, 5, 6) aufweist, welche den scheibenförmigen Gegenstand zumindest gegen Bewegungen in Scheibenebene fixieren. Der Greifer ist dadurch gekennzeichnet, dass an zwei gegenüberliegenden Flächen (1, 2) des Greifers Ausströmöffnungen (3) und Stabilisierungseinrichtungen (4, 5, 6) angeordnet sind, wobei der Greifer aus zwei oder drei durchgehenden Schichten mit im Wesentlichen gleichen Konturen besteht, nämlich einer ersten Schicht mit einer ersten Fläche (1) mit Ausströmöffnungen (3) und Stabilisierungseinrichtungen (4, 6), gegebenenfalls einer Trennschicht, und einer zweiten Schicht mit einer zweiten Fläche (2) mit Ausströmöffnungen (3) und Stabilisierungseinrichtungen (5).

## Beschreibung

Die Erfindung betrifft einen Greifer zum Handhaben dünner scheibenförmiger Gegenstände, insbesondere Wafer in der Halbleitertechnik, wobei der Greifer Ausströmöffnungen aufweist, mit denen ein hydrodynamischer Unterdruck erzeugt werden kann, der eine zum Greifer gerichtete Kraft auf einen scheibenförmigen Gegenstand ausübt. Die Erfindung kann aber nicht nur bei Wafern aus Silizium, sondern auch Substraten aus anderen Grundmaterialen verwendet werden.

Solche Greifer sind etwa aus der Veröffentlichung EP 1 291 901 A2 bekannt, die einen Greifer zeigen, bei dem Mittels Bernoulli-Effekt ein hydrodynamischer Unterdruck erzeugt wird, mit dem ein Wafer gehalten werden kann. Dieses Prinzip muss daher hier nicht näher erläutert werden. Bekannterweise können Wafer, insbesondere Dünnwafer bis 40 µm Dicke) sehr stark verspannt und durchgebogen sein. Mit Hilfe des Bernoulli-Effekts können auch Dünnwafer schonend eben ausgerichtet (planarisiert) werden. Da der Bernoulli-Effekt aber immer noch eine Verschiebung des scheibenförmigen Gegenstandes in der Scheibenebene zulässt, müssen weitere Stabilisierungseinrichtungen vorgesehen werden, welche den scheibenförmigen Gegenstand zumindest gegen Bewegungen in Scheibenebene fixieren. Im Fall der EP 1 291 901 A2 sind dies mechanische Anschläge.

Allerdings kann mit dem in der EP 1 291 901 A2 gezeigten Greifer immer nur ein scheibenförmiger Gegenstand auf eine bestimmte Art aufgenommen werden. Ebenso zeigt die EP 1 091 389 A2 nur einen einseitigen Greifer.

Die WO 2000/078654 A1 zeigt die beidseitige Verwendung eines Greifers (transfer arm), allerdings weist dieser keine Ausströmöffnungen auf, mit denen ein hydrodynamischer Unterdruck erzeugt werden kann.

Wafer müssen oftmals für Fertigungs- oder Inspektionsprozesse mit der Prozessseite obenliegend, zentriert und ausgerichtet, auf eine ebene Fläche (z.B. einem Vakuum-Chuck) ohne störende Hebeeinrichtung (wie z.B. Hebe-Pins) transportiert und abgelegt werden, desweiteren natürlich auch von dort wieder aufgenommen und in eine Waferkassette (=Horde) zurücktransportiert werden.

In den Waferkassetten (Horden) werden Wafer in waagrechter Ausrichtung übereinander gestapelt. In der Regel müssen die Wafer dabei ab einem Durchmesser von 6 Zoll voneinander einen Mindestabstand von 4,75 mm haben. Die Wafer sind in der Horde nicht genau zentriert, es sind Lageabweichungen in waagrechter Richtung bis ca. 5 mm möglich.

Die Prozesseite der Wafer wird auch als Vorderseite oder Chipseite bezeichnet und ist jene Seite, auf welcher die Halbleiterschaltungen aufgebracht sind. Die Prozessseite von Wafern darf nur am sogenannten technischen Rand (= am gesamten Umfang ca. 2,5 mm radial nach innen) mechanisch berührt werden. Die Rückseite des Wafers, die in der Regel keine Halbleiterschaltungen aufweist, darf entsprechend vom Greifer überall berührt werden, hier kann der Wafer auch vollflächig am Greifer aufliegen. In speziellen Fällen (durch Schutzfolie abgedeckte Prozessseite oder Chipseite) darf auch die Rückseite des Wafers nicht mechanisch berührt werden und ist wie eine Prozessseite zu behandeln.

Eine Aufgabe der vorliegenden Erfindung besteht nun darin, einen Greifer zur Verfügung zu stellen, mit dem ein scheibenförmiger Gegenstand auf mehr als eine Art aufgenommen werden kann, wobei der Aufbau des Greifers möglichst einfach sein soll.

Diese Aufgabe wird durch einen Greifer gemäß Anspruch 1 gelöst. Dadurch, dass an zwei gegenüberliegenden Flächen des Greifers Ausströmöffnungen und

Stabilisierungseinrichtungen angeordnet sind, kann sowohl auf der einen als auch auf der anderen Fläche des Greifers ein scheibenförmiger Gegenstand aufgenommen werden. Ein und derselbe Gegenstand kann somit durch die eine oder die andere Fläche des Greifers, und damit auf zwei verschiedene Arten aufgenommen werden. Zusätzlicher Vorteil ist, dass mit einem Greifer auch gleichzeitig zwei scheibenförmige Gegenstände aufgenommen werden können.

Eine Ausführung des Greifers besteht darin, dass der Greifer aus drei durchgehenden Schichten mit im Wesentlichen gleichen Konturen besteht, nämlich einer ersten Schicht mit einer ersten Fläche mit Ausströmöffnungen, einer Trennschicht und einer zweiten Schicht mit einer zweiten Fläche mit Ausströmöffnungen. Die einzelnen Schichten können getrennt hergestellt und anschließend zum Greifer zusammengefügt werden. Dies ist auch praktisch für die Ausbildung der notwendigen Kanäle: wenn Kanäle auf jener Seite der Schicht angeordnet sind, die im zusammengebauten Zustand auf der Trennschicht aufliegt, so stellt die Trennschicht gleich eine Begrenzung für den jeweiligen Kanal dar. Die Kanäle können hierzu einfach auf einer Seite in die Schicht z.B. eingefräst werden.

Die Trennschicht kann auch komplett entfallen. Wenn erste und zweite Fläche getrennt versorgt werden, dürfen sich die auf der jeweiligen Innenseite der ersten und zweiten Schicht befindlichen Versorgungskanäle nicht überschneiden. Dies ist erfüllt, wenn diese z.B. auf verschiedenen konzentrischen, aber unterschiedlichen Kreisdurchmessern liegen. Die Trennung der Kanäle von Ober- und Unterseite des Greifers muss erhalten werden.

Wenn erste und zweite Fläche gemeinsam versorgt werden, so sollten die Versorgungskanäle der ersten und zweiten Schicht deckungsgleich sein und jeweils einen gemeinsamen Kanal bilden.

In beiden Fällen bildet aber die jeweils andere Schicht die Begrenzung für die Versorgungskanäle.

Es kann vorgesehen werden, dass die Stabilisierungseinrichtungen der ersten Fläche so angeordnet sind, dass ein scheibenförmiger Gegenstand nur an dessen Randbereich am Greifer aufliegen kann und dass die Stabilisierungseinrichtungen der zweiten Fläche so angeordnet sind, dass ein scheibenförmiger Gegenstand innerhalb von dessen Randbereich flächig am Greifer aufliegen kann. Die erste Fläche des Greifers ist somit zur Aufnahme eines Wafers an dessen Prozessseite geeignet, die zweite Fläche zur Aufnahme eines Wafers an dessen Rückseite.

Es könnten aber auch beide Flächen des Greifers gleich ausgebildet werden. Das heißt, es können beide Seiten so ausgebildet sein, dass ein scheibenförmiger Gegenstand nur an dessen Randbereich am Greifer aufliegen kann oder so, dass auf beiden Seiten ein scheibenförmiger Gegenstand innerhalb von dessen Randbereich flächig am Greifer aufliegen kann.

Eine oder beide Flächen des Greifers können auch so ausgebildet sein, dass ein scheibenförmiger Gegenstand innerhalb des Randbereichs, etwa an Erhebungen des Greifers, am Greifer aufliegen kann. Diese Ausführung kann mit einer der vorgenannten Ausführungen kombiniert werden.

Eine Ausgestaltung der Erfindung besteht darin, dass zumindest ein Kanal im Greifer vorgesehen ist, der nur Ausströmöffnungen einer Fläche versorgt. Damit können beide Seiten unabhängig voneinander benützt werden, also etwa nur auf einer Seite ein Wafer aufgenommen werden, auf der anderen nicht.

Eine Alternative dazu besteht darin, dass zumindest ein Kanal vorgesehen ist, der Ausströmöffnungen beider Flächen versorgt. Dies hat den Vorteil, dass nur ein Kanal versorgt werden muss, aber gleichzeitig zwei Wafer gehandhabt werden können.

Natürlich wäre auch denkbar, dass man sowohl getrennte als auch gemeinsame Kanäle vorsieht.

Da der Bernoulli-Effekt zwar eine Kraft normal zur Ebene des scheibenförmigen Gegenstandes erzeugt, dieser aber in Scheibenebene bewegbar bleibt, kann vorgesehen werden, dass der Greifer an zumindest einer Fläche Ansaugöffnungen als Stabilisierungseinreichtungen aufweist, mit denen ein scheibenförmiger Gegenstand an den Greifer angesaugt werden kann. Mit diesen Ansaugöffnungen kann ein Unterdruck erzeugt werden, der z.B. einen Wafer am Greifer fixiert. Alternativ dazu können natürlich auch andere Fixiereinrichtungen, wie mechanische Anschläge oder elektromagnetische Halteeinrichtungen verwendet werden.

Wie für die Ausströmöffnungen kann - mit gleichen Vorteilen - auch für die Ansaugöffnungen vorgesehen werden, dass zumindest ein Kanal im Greifer vorgesehen ist, der nur Ansaugöffnungen einer Fläche versorgt, und/oder dass zumindest ein Kanal vorgesehen ist, der Ansaugöffnungen beider Flächen versorgt.

Eine besondere Ausführung von Ansaugöffnungen besteht darin, dass diese auf Erhebungen angebracht sind, deren Höhe der Höhe des Gaspolsters entspricht, der durch den Bernoulli-Effekt erzeugt wird. Damit ist sichergestellt, dass der durch die Ansaugöffnungen gehaltene scheibenförmige Gegenstand nur auf diesen Erhebungen mit dem Greifer in Kontakt kommt.

Die Ansaugöffnung kann einfach als Bohrung in der Erhebung ausgeführt sein. Es kann aber auch vorgesehen werden, dass zumindest eine Ansaugöffnung von einem Saugteller aus Elastomer umgeben ist. Hierzu wird etwa um die Bohrung der Ansaugöffnung ein ringförmiger Bereich ausgefräst, der einen Saugteller, also einen ringförmigen Teil aus einem Elastomer, aufnimmt.

Der Saugteller kann z.B. kreisringförmig sein, er kann aber auch Rechteckform haben mit einer Öffnung in der Mitte für die Ansaugöffnung.

Als Elastomer kommt etwa Katuschuk, wie Fluor-Kautschuk, in Frage. Für die Reinraumanwendung muss dieses Elastomer auf jeden Fall reinraumtauglich sein.

Insbesondere für die Bearbeitung von kreisförmigen Scheiben, wie Wafern, ist es für eine gleichmäßige Kraftaufbringung von Vorteil, wenn zumindest einige Ausströmöffnungen auf einer Kreislinie angeordnet sind.

Gleiches gilt auch für die Ansaugöffnungen: hier kann vorgesehen werden, dass zumindest einige Ansaugöffnungen auf einer Kreislinie angeordnet sind.

Wenn es eine zumindest teilweise kreisförmige Anordnung von Ausströmöffnungen gibt, so sollte vorteilhafterweise auch eine weitere zumindest teilweise kreisförmige Anordnung von Ausströmöffnungen oder von Ansaugöffnungen mit anderem Durchmesser konzentrisch zur ersten Anordnung sein.

Wenn der Greifer so ausgebildet ist, dass die Dicke, nämlich die größte Dicke, kleiner als 3,5 mm ist, so ist sichergestellt, dass der Greifer zwischen zwei in einem Materialträger (z.B. Kunststoffhorden für Wafer) angeordnete Scheiben eingeführt werden kann. Der Greifer kann für offene Anwendungen auch eine Dicke größer als 3,5 mm haben, insbesondere bis zu 15 mm.

Die Erfindung wird anhand der angeschlossenen Figuren 1 bis 3, die einen erfindungsgemäßen Greifer beispielhaft und schematisch darstellen, und der folgenden Beschreibungen erläutert. Es zeigen
Fig. 1 eine Ansicht der ersten Seite (Unterseite) eines Greifers mit einer Detailansicht A;
Fig. 2 eine Ansicht der zweiten Seite (Oberseite) der Greifers.
Fig. 3 eine weitere Detailansicht der ersten Seite (Unterseite) eines Greifers

Der Greifer gemäß den Fig. weist eine Halterung 7 auf, an welcher dieser an einem Roboterarm befestigt werden kann. In der Halterung sind auch hier nicht dargestellte Öffnungen für die Druckluft- und die Unterdruckversorgung des Greifers vorgesehen. Von der Halterung 7 aus verbreitert sich der Greifer in Längsrichtung, wobei die Kontur hier dem Durchmesser der handzuhabenden Scheiben angepasst ist und der Greifer um einige Millimeter größer als die Scheiben dimensioniert ist, weil mit dem Greifer in diesem Beispiel die Scheiben am Rand der Scheibenfläche gehalten werden sollen (und nicht entlang der Umfangskante). Der Greifer kann aber grundsätzlich auch kleiner als die handzuhabende Scheibe sein.

Die Abmessungen des Greifers folgen in Längsrichtung aber nicht weiter der kreisförmigen Kontur der Scheiben, sondern der Greifer behält in etwa die gleiche Breite, damit er so in eine Halterung, in der Scheiben gelagert sind, eingeführt werden kann.

Anschließend verkleinert sich die Breite des Greifers einer Kreislinie folgend so lange, bis zumindest die Breite der Halterung 7 erreicht ist. Die Breite in diesem Abschnitt wurde für dieses Beispiel so gewählt, dass zumindest zwei Stabilisierungseinrichtungen 4, 6 vorgesehen werden können, die am Rand eines Wafers mit vorgegebenem Durchmesser angreifen können.

Der Greifer endet in einer kreisförmigen Kontur, die in etwa jener der handzuhabenden Scheiben entspricht. Selbst verständlich kann die Kontur des Greifers für andere Anwendungen auch so gestaltet werden, dass dieser abgesehen von der Halterung 7 eine durchgehend kreisförmige Kontur aufweist. Dies hätte den Vorteil, dass Scheiben über einen weiteren Bereich nahe am Rand gehalten werden können.

Sowohl die Oberseite 2 als auch die Unterseite 1 bilden jeweils eine gerade ebene Fläche, nur ist die Unterseite 1 mit Erhebungen 6 versehen, auf denen der Wafer aufliegen darf. Die erste und zweite Fläche 1, 2 sind parallel zueinander ausgerichtet.

Zwei gleichzeitig vom Greifer gehaltene gleich große Wafer wären parallel zueinander und deckungsgleich ausgerichtet.

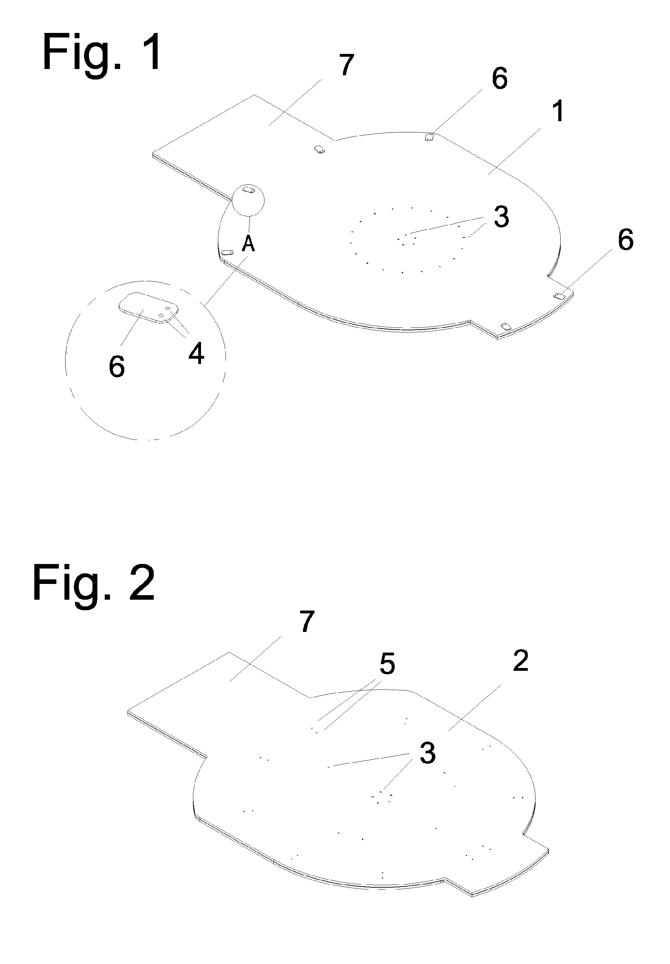

In Fig. 1 ist die erste Fläche (Unterseite) des Greifers dargestellt. Die Ausströmöffnungen 3 zur Erzeugung des hydrodynamischen Unterdrucks bilden zwei konzentrische Kreise, die Ausströmöffnungen 3 haben auf jedem Kreis den gleichen Abstand zu den benachbarten Ausströmöffnungen. Selbstverständlich können die Ausströmöffnungen 3 auch auf mehr als zwei konzentrischen Kreisen oder Kreissegmenten angeordnet werden. Die beiden konzentrischen Kreise der Ausströmöffnungen 3 sind auch konzentrisch zu den kreisförmigen Abschnitten der Kontur des Greifers. An diesen kreisförmigen Abschnitten der Kontur sind mehrere an ihrer Oberseite ebene Erhebungen 6 angeordnet, und zwar konzentrisch zu den durch die Ausströmöffnungen 3 gebildeten Kreise. Die Erhebungen 6 sind rechteckig, mit ihrer Längsseite radial ausgerichtet und haben abgerundete Kanten. Nahe der inneren Breitseite sind jeweils zwei runde Ansaugöffnungen 4 angeordnet, mit denen mittels Unterdruck eine Scheibe fixiert werden kann. Die Anordnung der Erhebungen 6 bzw. der Ansaugöffnungen 4 ist derart, dass eine Scheibe mit vorgegebenem Durchmesser in ihrem Randbereich auf den Ansaugöffnungen 4 aufliegt.

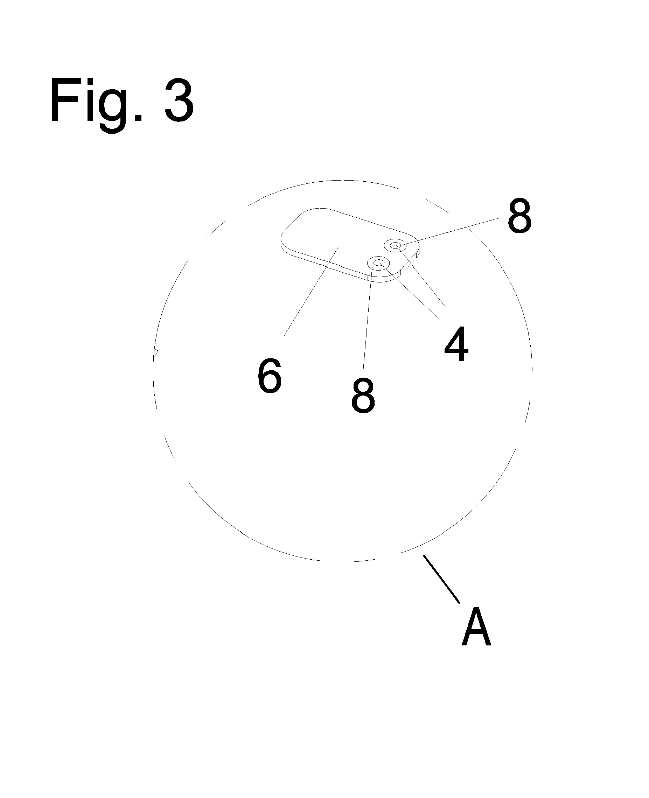

In Fig. 3 ist eine andere Ausbildung der Ansaugöffnungen 4 gezeigt. Und zwar wird hier jede Ansaugöffnung von einem kreisringförmigem Saugteller 8 aus Elastomer umgeben. Hierzu wird um die Bohrung der Ansaugöffnung 4 ein ringförmiger Bereich heruasgearbeitet, sodass der Saugteller 8 eingesetzt werden kann. Er ist in diesem Beispiel aus Fluor-Kautschuk gefertigt.

Der Saugteller kann auch eine andere Form haben, etwa rechteckig.

Der Greifer in diesem Beispiel ist für 8 Zoll-Wafer ausgelegt, diese haben also einen Durchmesser von etwa 20 cm und dürfen auf deren Prozessseite am sogenannten technischen Rand, das sind etwa 2,5 bis 3 mm vom Umfang einwärts, berührt werden.

Nur in diesem Bereich dürfen die Erhebungen 6 mit ihren Ansaugöffnungen 4 angreifen.

Für 6 Zoll-Wafer ist der Greifer an den 150 mm Wafer-Durchmesser anzupassen. Für 12 Zoll-Wafer ist der Greifer an den 300 mm Wafer-Durchmesser anzupassen. Der Greifer kann natürlich auch an jede andere Substratgröße und Substratform (z.B. rechteckig) angepasst werden.

In Fig. 2 ist die zweite Fläche (Oberseite) des Greifers dargestellt. Auch auf der Oberseite 2 liegen die Ausströmöffnungen 3 zur Erzeugung des hydrodynamischen Unterdrucks auf zwei konzentrischen Kreisen, die ebenfalls konzentrisch zu den kreisförmigen Abschnitten der Kontur des Greifers sind. Allerdings weisen hier die einzelnen Ausströmöffnungen 3 auf einem Kreis unterschiedliche Abstände zueinander auf.

Die Ansaugöffnungen 5 sind hier in zwei konzentrischen Kreisen angeordnet und befinden sich in der Ebene der zweiten Seite 2 (und nicht auf Erhebungen 6 wie auf der ersten Seite 1).

Die Ansaugöffnungen 4, 5 werden hier durch gerade Bohrungen hergestellt, die Ausströmöffnungen 3 durch schräge Bohrungen. Die Ausströmöffnungen 3 können auf den konzentrischen Kreisen mit jeweils gleichem Abstand zueinander oder unregelmäßig verteilt sein. Die genaue Anordnung der Ausströmöffnungen 3 für die Erzielung des Bernoulli-Effekts liegen im Können des Fachmanns und sind daher hier nicht näher zu erläutern. Als Medium für die Ausströmöffnungen 3 können entsprechend vorbehandelte

Druckluft, aber auch andere Gase wie z.B. Stickstoff zum Einsatz kommen.

Der Greifer ist schichtartig aufgebaut. Die erste Schicht bildet nach außen die erste Fläche 1 (Unterseite), die zweite Schicht bildet nach außen die zweite Fläche (Oberseite) 2. Die beiden Schichten sind in diesem Beispiel durch die Trennschicht vollkommen voneinander getrennt. Die beiden Schichten und die Trennschicht haben die gleiche

Kontur.

Dadurch sind auch die Kanäle zur Versorgung der einzelnen Öffnungen 3, 4, 5 für jede Seite getrennt. Es kann vorgesehen sein, dass alle Ausströmöffnungen 3 einer Seite durch einen einzigen Kanal mit Gas versorgt werden oder dass einzelne Abschnitte (z.B. Kreisringe, Kreissegmente, Kreissektoren) einer Seite 1, 2 jeweils einen gemeinsamen Kanal haben. Gleiches gilt für die Ansaugöffnungen 4, 5.

Die erste und zweite Schicht sind in diesem Beispiel aus Aluminium gefertigt und an der Oberfläche mit einem Oberflächenschutz versehen, z.B. anodisch behandelt, um eventuellen Reinraumanforderungen gerecht zu werden. Sie haben in diesem Beispiel jeweils eine Dicke von 1,4 mm. Die Trennschicht besteht hier aus einer Edelstahlfolie mit einer Dicke von etwa 0,2 mm. Die einzelnen Schichten werden miteinander verklebt. Die Erhebungen 6 auf der Unterseite 1 sind etwa zwischen 0,15 bis 0,45 mm hoch.

Die Trennschicht kann aber auch aus Kunststoff bestehen.

In den Greifer, insbesondere in die Unterseite 1, können, je nach Anforderung, ein oder mehrere Sensoren eingebaut werden, mit dem Zweck, das Vorhandensein eines Wafers per elektrischem Signal zu melden. Der Greifer kann auf alle handelsüblichen Roboter und Linearantriebssysteme montiert werden.

Der erfindungsgemäße Greifer kann insbesondere:
1. mit seiner komplett ebenen Oberseite 2, Wafer (auch Dünnwafer bis 50 µm Dicke) an der Rückseite mit dem Bernoulli-Effekt planarisieren und danach mit Vakuum ansaugen, z.B. für den Transport aus einer Horde zu einer Zentrier- und Ausrichtstation (=Pre-Aligner bzw. Flater/Orienter),
2. mit seiner Unterseite 1 den zentrierten und ausgerichteten Wafer vom Pre-Aligner an der Prozessseite mit dem Bernoulli-Effekt planarisieren und mit Vakuum nur am technischen Rand ansaugen, ohne den Wafer am Umfang mit mechanischen Anschlägen zu begrenzen, z.B. für den Transport vom Pre-Aligner zu einem Prozesschuck,
3. einen Wafer auf eine ebene Fläche (z.B. auf einen Prozesschuck) von oben lagerichtig und zentriert ablegen,
4. einen Wafer lagerichtig, von z.B. einem Prozesschuck, aufnehmen, sowie
5. einen Wafer direkt in eine Horde zurücktransportieren und ablegen.

Grundsätzlich können aber Ober- und Unterseite des Greifers auch anders ausgebildet werden, etwa beide Seiten wie die Oberseite im Beispiel oder beide Seiten wie die Unterseite im Beispiel. Es können aber auch eine oder beide Seiten mit Erhebungen 6 ausgeführt sein, die so angeordnet sind, dass ein scheibenförmiger Gegenstand innerhalb seines Randbereichs an diesem Erhebungen aufliegt.

### Bezugszeichenliste:

- 1: erste Fläche (Unterseite)
- 2: zweite Fläche (Oberseite)
- 3: Ausströmöffnung
- 4: Ansaugöffnung auf erster Fläche
- 5: Ansaugöffnung auf zweiter Fläche

- 6: Erhebung für Ansaugöffnung 4
- 7: Halterung
- 8: Saugteller

## Patentansprüche

1. Greifer zum Handhaben dünner scheibenförmiger Gegenstände, insbesondere Wafer in der Halbleitertechnik, wobei der Greifer Ausströmöffnungen (3) aufweist, mit denen ein hydrodynamischer Unterdruck erzeugt werden kann, der eine zum Greifer gerichtete Kraft auf einen scheibenförmigen Gegenstand ausübt, und wobei der Greifer weiters Stabilisierungseinrichtungen (4, 5, 6) aufweist, welche den scheibenförmigen Gegenstand zumindest gegen Bewegungen in Scheibenebene fixieren, **dadurch gekennzeichnet, dass** an zwei gegenüberliegenden Flächen (1, 2) des Greifers Ausströmöffnungen (3) und Stabilisierungseinrichtungen (4, 5, 6) angeordnet sind, wobei der Greifer aus zwei oder drei durchgehenden Schichten mit im Wesentlichen gleichen Konturen besteht, nämlich einer ersten Schicht mit einer ersten Fläche (1) mit Ausströmöffnungen (3) und Stabilisierungseinrichtungen (4, 6), gegebenenfalls einer Trennschicht, und einer zweiten Schicht mit einer zweiten Fläche (2) mit Ausströmöffnungen (3) und Stabilisierungseinrichtungen (5).

2. Greifer nach Anspruch 1, **dadurch gekennzeichnet, dass** die Stabilisierungseinrichtungen (4, 5, 6) der ersten Fläche (1) so angeordnet sind, dass ein scheibenförmigen Gegenstand nur an dessen Randbereich am Greifer aufliegen kann und dass die Stabilisierungseinrichtungen (4, 5, 6) der zweiten Fläche (2) so angeordnet sind, dass ein scheibenförmigen Gegenstand innerhalb von dessen Randbereich flächig am Greifer aufliegen kann.

3. Greifer nach Anspruch 1 oder 2, **dadurch gekennzeichnet, dass** der Greifer an zumindest einer Fläche (1, 2) Ansaugöffnungen (4, 5) als Stabilisierungseinrichtungen aufweist.

4. Greifer nach einem der Ansprüche 1 bis 3, **dadurch gekennzeichnet, dass** Ansaugöffnungen (4) auf Erhebungen (6) angebracht sind, deren Höhe der Höhe des Gaspolsters entspricht, der durch den hydrodynamischer Unterdruck erzeugt wird.

5. Greifer nach Anspruch 3 oder 4, **dadurch gekennzeichnet, dass** zumindest eine Ansaugöffnung (4) von einem Saugteller (8) aus Elastomer umgeben ist.

6. Greifer nach einem der Ansprüche 1 bis 5, **dadurch gekennzeichnet, dass** Kanäle auf jener Seite der Schicht angeordnet sind, die im zusammengebauten Zustand auf der Trennschicht aufliegt, sodass die Trennschicht eine Begrenzung für den jeweiligen Kanal darstellt.

7. Greifer nach einem der Ansprüche 1 bis 5, **dadurch gekennzeichnet, dass** keine Trennschicht angeordnet ist und Kanäle auf jener Seite der Schicht angeordnet sind, die im zusammengebauten Zustand auf der anderen Schicht aufliegt, sodass die jeweils andere Schicht eine Begrenzung für den jeweiligen Kanal darstellt.

8. Greifer nach einem der Ansprüche 1 bis 7, **dadurch gekennzeichnet, dass** zumindest einige Ausströmöffnungen (3) auf einer Kreislinie angeordnet sind.

9. Greifer nach einem der Ansprüche 1 bis 8, **dadurch gekennzeichnet, dass** zumindest einige Ansaugöffnungen (4, 5) auf einer Kreislinie angeordnet sind.

10. Greifer nach einem der Ansprüche 8 bis 9, **dadurch gekennzeichnet, dass** zumindest eine Kreislinie für Ausströmöffnungen (3) und/oder eine Kreislinie für für Ansaugöffnungen (4, 5) konzentrisch ist zu einer weiteren Kreislinie für Ausströmöffnungen (3) und/oder Ansaugöffnungen (4, 5).

11. Greifer nach einem der Ansprüche 1 bis 10, **dadurch gekennzeichnet, dass** die Dicke des Greifers kleiner als 15 mm, insbesondere kleiner als 3,5 mm, ist.

12. Verwendung eines Greifers nach einem der Ansprüche 1 bis 11 zum gleichzeitigen Handhaben zweier scheibenförmiger Gegenstände.

13. Verwendung eines Greifers nach einem der Ansprüche 2 bis 11 zum Transportieren eines scheibenförmigen Gegenstandes, insbesondere eines Wafers, der mit seiner Rückseite an der zweiten Fläche (2) des Greifers anliegt.

14. Verwendung eines Greifers nach einem der Ansprüche 2 bis 11 zum Transportieren eines scheibenförmigen Gegenstandes, insbesondere eines Wafers, der mit seiner Prozessseite an den Stabilisierungseinrichtungen (4, 6) der ersten Fläche (1) des Greifers anliegt.
